# EUROPEAN PATENT APPLICATION

(11) **EP 4 016 654 A1**
(43) Date of publication of application: **22.06.2022**
(21) Application number: 21198789.6
(22) Date of filing: 24.09.2021
(51) Int. Cl.: H01L 49/02

(54) **INTEGRATED CIRCUIT DEVICE HAVING BACKEND DOUBLE-WALLED CAPACITORS**

(30) Priority: 21.12.2020 US 202017129875
(71) Applicant: Intel Corporation, Santa Clara, CA 95054 (US)
(72) Inventor: CHANDHOK, Manish, Beaverton, 97006 (US); YOO, Hui Jae, Hillsboro, OR 97124-6463 (US); CLENDENNING, Scott B., Portland, 97225 (US); LE, Van H., Beaverton, 97007 (US); NASKAR, Sudipto, Portland, 97229 (US); SHARMA, Abhishek A., Hillsboro, 97229 (US); SATO, Noriyuki, Hillsboro, 97124 (US); LEE, Sudarat, Hillsboro, 97124 (US)
(74) Representative: HGF

(57) **Abstract**

An integrated circuit (IC) structure having a plurality of backend double-walled capacitors (DWCs) are described. In an example, a first interconnect layer is disposed over a substrate and a second interconnect layer is disposed over the first interconnect layer. In the example, a plurality of DWCs are disposed in the first interconnect layer or the second interconnect layer to provide capacitance to assist the first interconnect layer and the second interconnect layer in providing electrical signal routing and power distribution to one or more devices in the IC structure. In examples, the IC structure includes a logic IC or a coupling substrate.

## Description

### TECHNICAL FIELD

Embodiments of the disclosure are in the field of integrated circuit structures and, in particular, integrated circuit devices including backend double-walled capacitors.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant. For example, to maintain the fidelity of power in a chip, metal-insulator-metal (MIM) capacitors may typically be used. As the name indicates, MIM capacitors have an insulator sandwiched between two metal plates. Unfortunately, in the MIM configuration, the metal plates must have a relatively significant surface area in order to achieve desired capacitance.

### BRIEF DESCRIPTION OF THE DRAWINGS

Figures 1A- and 1B illustrate simplified top views of backend double-walled capacitors (DWCs), in accordance with an embodiment of the present disclosure.
Figures 1C and 1D illustrate various arrangements of backend double-walled capacitors (DWCs), in accordance with an embodiment of the present disclosure.
Figure 2A illustrates a cross-sectional side view of the backend DWC of Figures 1 and 2, in accordance with an embodiment of the present disclosure.
Figures 2B and 2C illustrate a respective dielectric layer and metal layer of the DWC of Figure 2A, in accordance with embodiments of the present disclosure.
Figure 3 illustrates cross-sectional views of an integrated circuit (IC) device having a plurality of backend DWCs, in accordance with an embodiment of the present disclosure.
Figures 4A - 4M illustrate cross-sectional views representing various operations in a method of fabricating a backend DWC, such as DWC 100 of Figures 1 and 2, in accordance with an embodiment of the present disclosure.
Figure 5 is a cross-sectional side view of an integrated circuit (IC) device and assembly that may include one or more backend DWCs, in accordance with one or more of the embodiments disclosed herein.
Figure 6 is a cross-sectional side view of an integrated circuit (IC) device assembly that may include one or more backend DWCs, in accordance with one or more of the embodiments disclosed herein.
Figure 7 illustrates a computing device in accordance with one implementation of an embodiment of the disclosure.

### DESCRIPTION OF THE EMBODIMENTS

Integrated circuit devices having double-walled capacitors (DWCs) are described. In embodiments, the DWCs are backend DWCs. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

To provide context, certain types of DWCs have been used in DRAM memory. In DRAM memory, the DWCs may serve as a storage element be located directly on or proximal to a transistor. DWCs are not currently used in logic devices, e.g., in BEOL interconnect layers of a logic device. Nor are DWCs used to assist in providing capacitance for substrates or devices providing interconnection between electronic devices. Advantages to implementing embodiments described herein can include the ability to provide greater capacitance while utilizing a smaller area in various IC environments.

Embodiments include an integrated circuit (IC) structure including a plurality of interconnect layers. In embodiments, a plurality of backend DWCs are disposed in one or more of the plurality of interconnect layers of to provide capacitance to assist the first interconnect layer and the second interconnect layer in providing electrical signal routing to one or more devices in the IC structure.

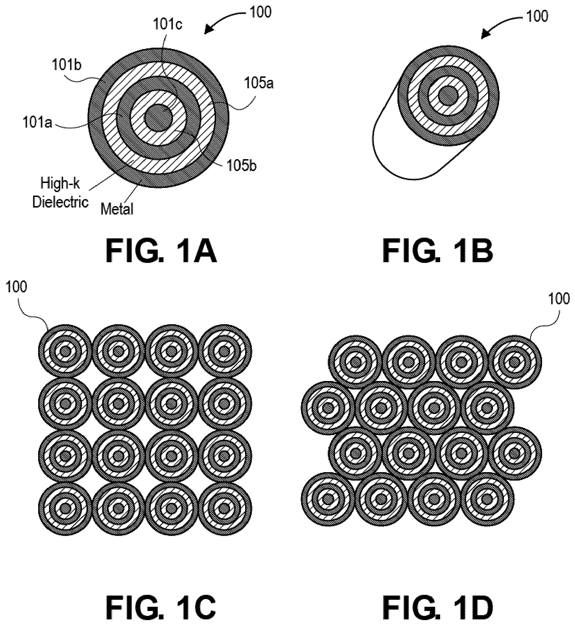

Figures 1A and 1B illustrate simplified top views of a double-walled capacitor (DWC) while Figures 1C and 1D illustrate various arrangements of a plurality of DWCs, in accordance with embodiments of the present disclosure. In embodiments, the DWCs are backend DWCs. As shown, Figures 1A and 1B illustrate respective top (top-cross-sectional) and perspective views of a DWC 100 having double walls made of metal layers 101a and 101b. In embodiments, each of the plurality of DWCs include a cylindrical double-walled capacitor including alternating dielectric layers and metal layers. The configuration of the DWC 100 including alternating metal layers 101a and 101b and dielectric layers 105a and 105b provide increased capacitance, e.g., as compared to a conventional MIM structures. DWC 100 also includes a metal layer 101c in the middle of DWC 100. Note that in order not to obscure the figures, like elements in Figure 1B have not been relabeled.

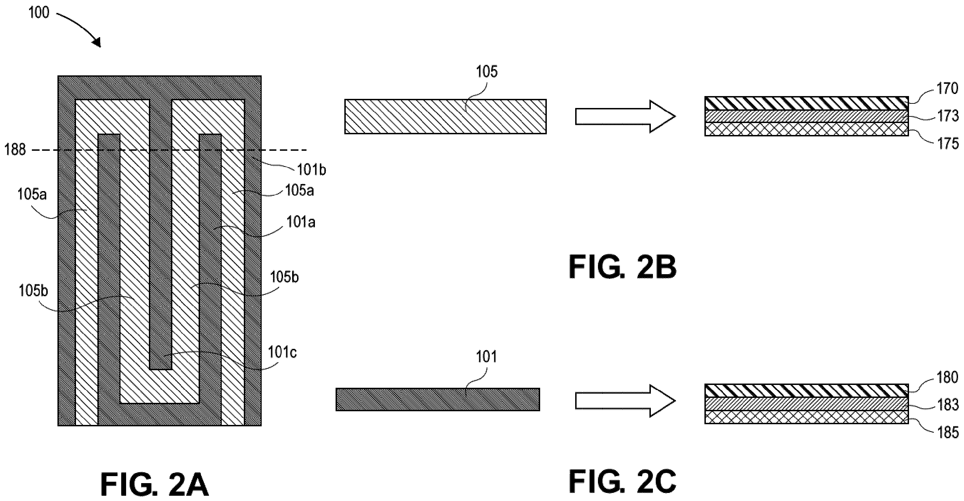

Figures 1C and 1D illustrate possible arrangements of a plurality of DWCs, such as DWC 100 of FIG.1A and FIG.1B. FIG.1C illustrate a row and column configuration, also referred to herein as a Manhattan configuration. FIG.1D illustrates a staggered configuration also referred to herein as a honeycomb or honeycomb-style configuration. As can be seen from FIG.1D, in some embodiments, the honeycomb-style configuration provides more density of DWCs per area than the Manhattan configuration. Note that the Manhattan configuration and the honeycomb configuration are merely examples of possible arrangements of the plurality of DWCs. In various embodiments, any suitable arrangement of the plurality of the DWCs that provides a desired capacitance and density for an interconnect layer (as will be discussed in connection with Figure 2) may be contemplated.

Referring now to Figure 2A which illustrates a cross-sectional side view of DWC 100 of Figure 1A and 1B, in accordance with an embodiment of the present disclosure. Note that a dotted line 188 represents a cut across which corresponds to the top cross-sectional views of Figures 1A and 1B. Figure 2A illustrates the configuration of the DWC 100 including alternating metal layers (or walls) 101a and 101b and insulating layers, e.g., dielectric layers 105a and 105b. Inner metal layer 101c is shown in the middle of DWC 100.

Figure 2B illustrates a side view of a portion of an insulating layer, e.g., dielectric layer 105 (e.g., 105a and 105b). In some embodiments, dielectric layer 105 is a single layer or includes a multi-layer stack of dielectric materials, e.g., one to three layers (or more). A three-layer stack may include e.g., layers 170, 173, and 175. In embodiments, the dielectric materials include a high-k dielectric material with k >20 (like hafnium oxide (HfO₂), zirconium oxide (ZrO₂), titanium dioxide (TiO₂), strontium titanium oxide (SrTiO₃). In embodiments, the dielectric layer is also composed of a material such as, but not limited to, hafnium oxy-nitride, hafnium silicate, lanthanum oxide, zirconium silicate, hafnium zirconium oxide, tantalum oxide, barium strontium titanate, barium titanate, strontium titanate, yttrium oxide, aluminum oxide, lead scandium tantalum oxide, lead zinc niobate, and rare-earth oxides including forms of M₂O₃ or a combination thereof.

In embodiments, the dielectric materials singularly or in combination also may have a property such as a wide bandgap for low leakage, such as but not limited to, aluminum oxide (Al2O₃), hafnium xxide (HfO₂), zirconium oxide (ZrO₂), silicon nitride (SiN), silicon oxide (SiO₂), silicon oxynitride (SiON), silicon carbide (SiC), aluminum nitride (AIN), zirconium nitride (ZrN), hafnium nitride, (HfN), and gallium nitride (GaN). Embodiments may include dielectric materials including electric double layers (ionic electrolytes like LiPON etc). Note that in embodiments, the layers, e.g., 170, 173, and 175, can be used in combination or in isolation as a multilayer stack or a stand-alone layer.

Figure 2C illustrates a side view of a portion of a metal layer 101, e.g., metal layers (or walls) 101a, 101b, or 101c. In some embodiments, metal layer 101 is a single layer. In other layers, metal layer 101 includes a multi-layer stack of metallic materials, e.g. one to three (or more) layers. A three-layer stack may include e.g., layers 180, 183, and 185. In embodiments, the metallic materials include high conductivity material, such as for example but not limited to, copper (Cu), titanium nitride (TiN), tantalum nitride (TaN), titanium (Ti), (tantalum) Ta, and Graphene. Note that in embodiments, metal layer 101a and 101c may include same or different materials with the same or different work functions (e.g., ruthenium (Ru) vs. copper (Cu), copper (Cu) vs. zinc (Zn) etc.). Note that in embodiments, layers e.g. layers 180, 183, and 185 can be used in combination or in isolation as a multilayer stack or a stand-alone layer.

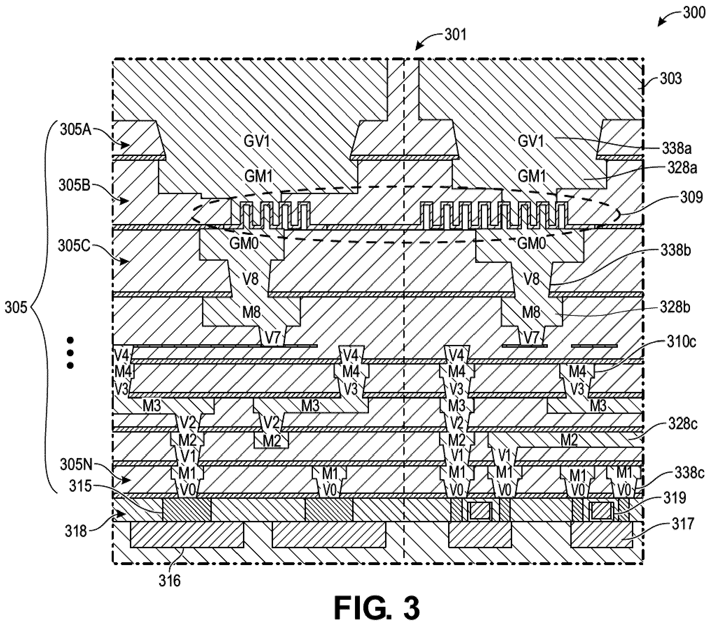

Referring now to Figure 3 which illustrates a cross-sectional view of an integrated circuit (IC) device 300 having a plurality of DWCs, in accordance with an embodiment of the present disclosure. In Figure 3, a cross-sectional view is shown (cut along an axis 301). Elements on a left side of dotted line 301 include a "parallel to gate" cross-sectional view of IC device 300, while elements on a right include a "perpendicular to gate" cross-sectional view. Note that in some Figures, similar elements may not be relabeled in order to avoid obscuring the Figure. IC device 300 includes a plurality of DWCs 309 (e.g., backend DWCs) which are included in an interconnect layer 305B. Interconnect layer 305B is included in a plurality of or a stack of interconnect layers 305 including, e.g. 305A-305N.

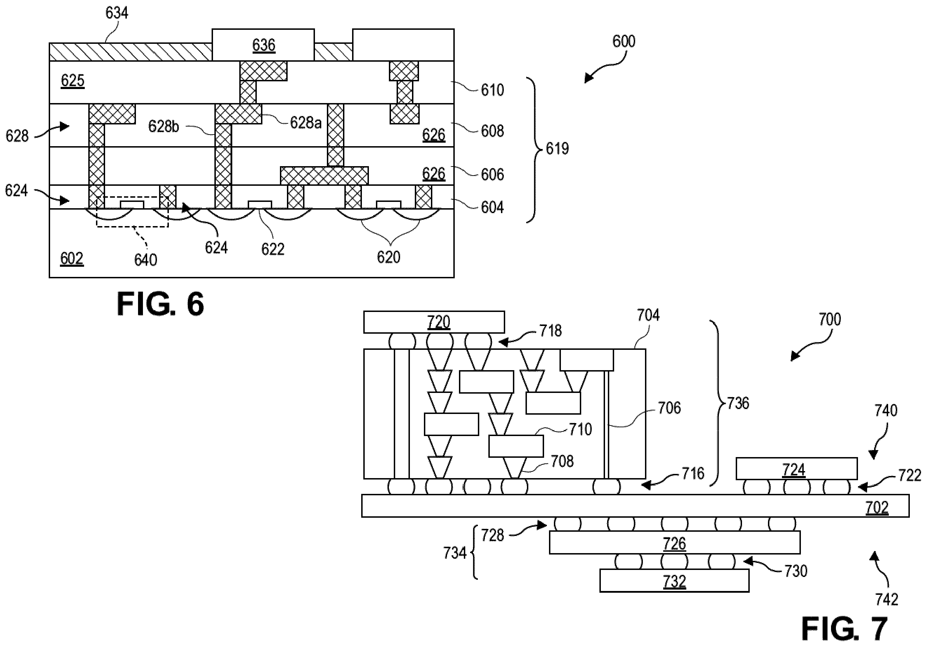

As seen in Figure 3, stack of interconnect layers 305 includes various electrically conductive interconnect structures such as lines or trench structures 328 (e.g., 328a, 328b, 328c) and vias 338 (e.g., 338a, 338b, 338c). Note that only a few of trench structures 328 and vias 338 have been labeled in order to avoid obscuring the figure. In Figure 3, lines or trench structures 328 are also labeled according to an interconnect layer they may be in, relative to the first layer over a device layer (or ground), e.g., Metal 1 or "M1", Metal 2 or "M2", Metal 3 or "M3", "Ground Metal 1" or "GM1", etc. Vias are labeled similarly, however, begin with Via 1 or "V1", Via 2 or "V2", Ground Via 1 or "GV1" etc. Further details about the content, configuration, and materials of the interconnect structures, interconnect layers, and device layers are also discussed with respect to Figure 6 below. As shown, an interconnect layer 305A is connected to a solder bump or bond pad 303. In some embodiments, bond pad 303 may provide contact between a chip package and a circuit board or between stacked packages in a multi-chip module.

In embodiments, plurality of DWCs 309 provide capacitance to assist stack of interconnect layers 305 in providing electrical signal routing and power distribution to one or more devices in IC structure 300. In the embodiment, devices in IC structure 300 include devices 316 and 317 shown in a substrate, e.g., a silicon substrate. A device layer 318 includes a gate 319 and diffusion contacts 315 (note only one is labeled in the Figure) for devices 316 and 317. In embodiments, devices 316 and 317 may include N-channel metal-oxide-semiconductor field-effect transistor (NMOS) transistors and/or P-channel metal-oxide-semiconductor field-effect transistor (PMOS) transistors (further discussed with respect to Figure 6). Note that in embodiments, devices 316 and 317 are located on a substrate (or in other embodiments, a device layer) different from an interconnect layer or location of one or more of, or the plurality of DWCs 309. In some embodiments, the vias include through-silicon vias (TSVs).

It is appreciated that although plurality of DWCs 309 are shown in interconnect layer 305B, the plurality of DWCs 309 may be located in any suitable layer of an IC device, in order to assist in providing electrical signal routing and power distribution among components of the IC device. Furthermore, IC structure 300 is merely exemplary and may vary in a number of layers, electronic components, location of the device layers, etc.

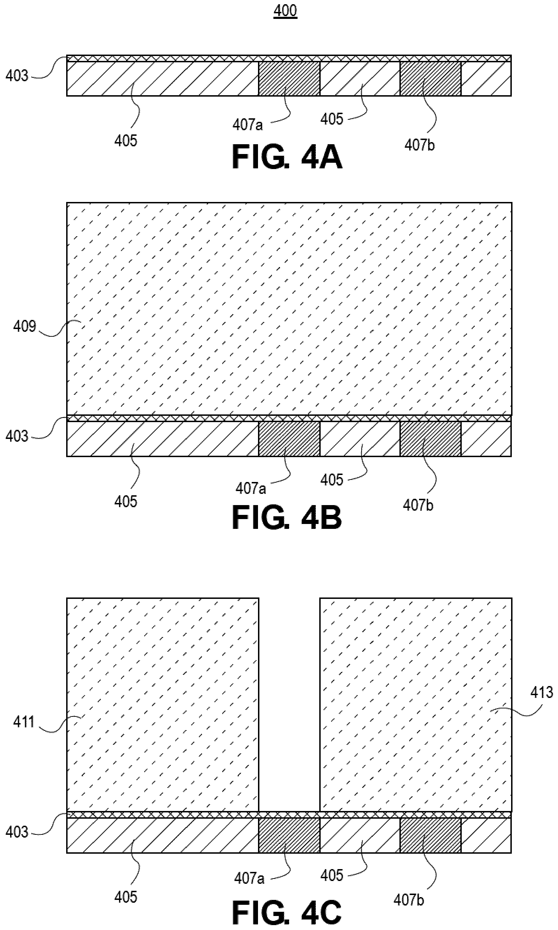

Figures 4A-4M illustrate cross-sectional views representing various operations in a method of fabricating a DWC, e.g., a backend such as DWC 100 of Figures 1 and 2, in accordance with an embodiment of the present disclosure. Note that in some Figures, certain elements that have been previously described may not be reintroduced or relabeled.

Referring to Figure 4A, a starting structure 400 includes a foundational layer including an inter-layer dielectric (ILD) 405 and a first metal layer contact 407a and a second metal layer contact 407b. An underlayer or etch stop (ES) layer 403 has been deposited over ILD 405 and first metal layer contact 407a and first metal layer contact 407b have been formed. In embodiments, starting structure 400 is formed over a substrate such as a silicon substrate.

Next, in Figure 4B, a sacrificial layer 409 is formed or deposited over ES 403. In embodiments, sacrificial layer 409 may include Silicon Dioxide (SiO₂). In various other embodiments, sacrificial layer 409 may include Silicon Nitride (SiN), Cadmium Oxide (CDO), or any other suitable materials that allow or provide for deep etching.

Referring now to Figure 4C, patterning and lithography of a first structure 411 and a second structure 413, on which capacitor walls will later be formed, is performed. In some embodiments, a hard mask (HM) layer above sacrificial layer 409 has been deposited and removed (not shown). The HM layer may include materials such as, e.g., silicon nitride (SiN), silicon (Si), silicon carbide (SiC), silicon oxide (SiO₂), silicon oxynitride (SiON), carbon-doped oxide (CDO,) aluminum oxide (Al₂O₃), hafnium oxide (HfO₂), zirconium oxide (ZrO₂), aluminum nitride (AIN), zirconium nitride (ZrN), and hafnium nitride (HfN).

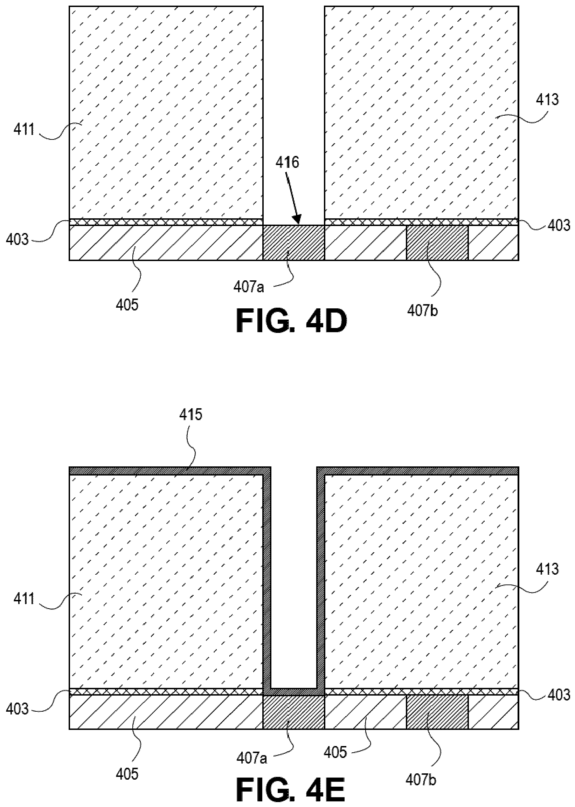

Referring now to Figure 4D, etching or removal of a portion of ES 403 between first structure 411 and second structure 413 is performed. In particular, first metal layer contact 407a is now exposed at 416.

Referring now to Figure 4E, an electrode layer 415 is deposited over first structure 411, second structure 413, and first metal layer contacts 407a. In embodiments, electrode layer 415 is deposited in a conformal manner and includes an electrically conductive material. In embodiments, the electrode layer 415 is formed of multiple layers and may include materials discussed in connection with Figure 2C.

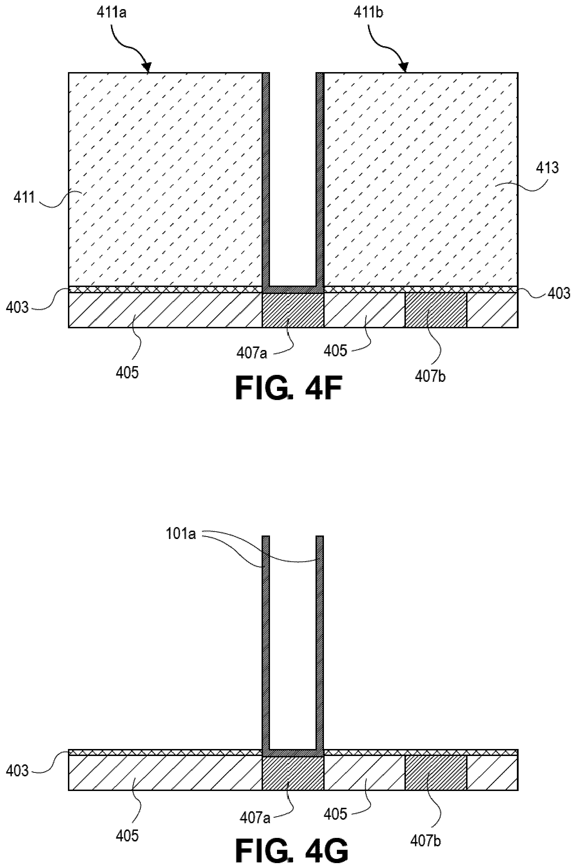

Referring now to Figure 4F, electrode layer 415 is polished and removed from top surfaces 411a and 411b of first structure 411 and second structure 413.

Referring now to Figure 4G, etching of sacrificial material is performed to remove previous first structure 411 and second structure 413. As a result, a metal layer or a metal wall structure 101a is formed. Note that when an aspect ratio of the metal wall structure is high, a supporting structure in downstream processing may be required, in order to avoid pattern collapse.

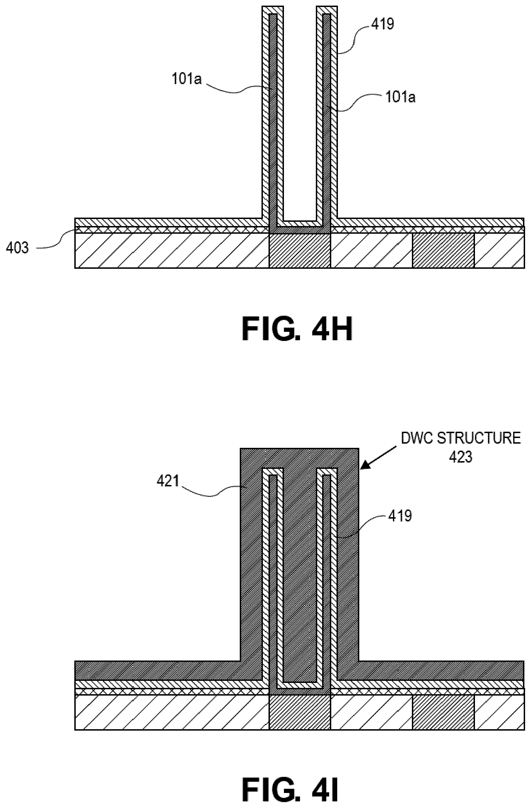

Referring now to Figure 4H, deposition of an insulator material, e.g., a high-k material 419 over wall metal wall structure 101a as well as ES 403 is performed. Note that multiple high-k material layers (not shown) may be deposited. Examples of high-k materials are discussed with respect to Figure 2B.

Referring now to Figure 4I, deposition of an electrode layer 421 over high-k material 419 is performed to form a backend DWC structure 423. In embodiments, electrode layer 421 is conformal and is made of an electrically conductive material. Note that multiple layers (not shown) may be deposited. Examples of metallic materials that may be used for electrode layer 421 are discussed with respect to Figure 2C.

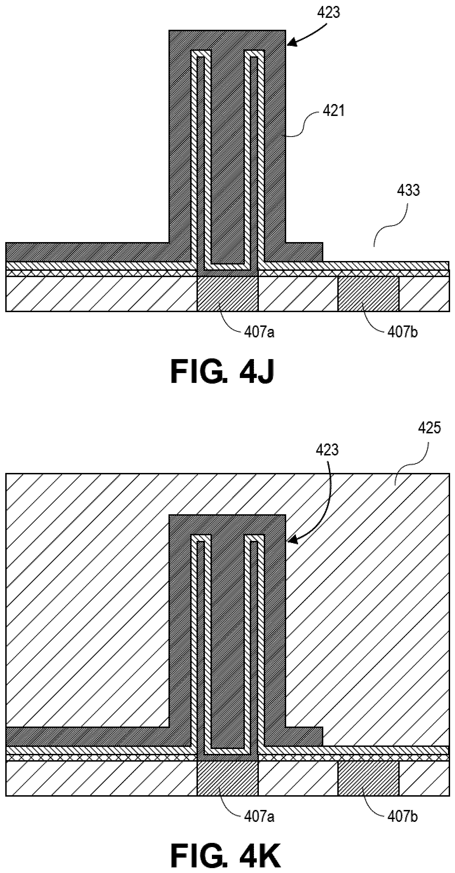

Referring now to Figure 4J, lithography and etching of electrode layer 421 is performed to open an area at 433 above second metal contact layer 407b.

Referring now to Figure 4K, deposition and polishing of an ILD material 425 over DWC structure 423 and the area at 433 is performed. The ILD material 425 may be formed by conventional techniques, such as, for example, chemical vapor deposition (CVD), physical vapor deposition (PVD), or by other deposition methods.

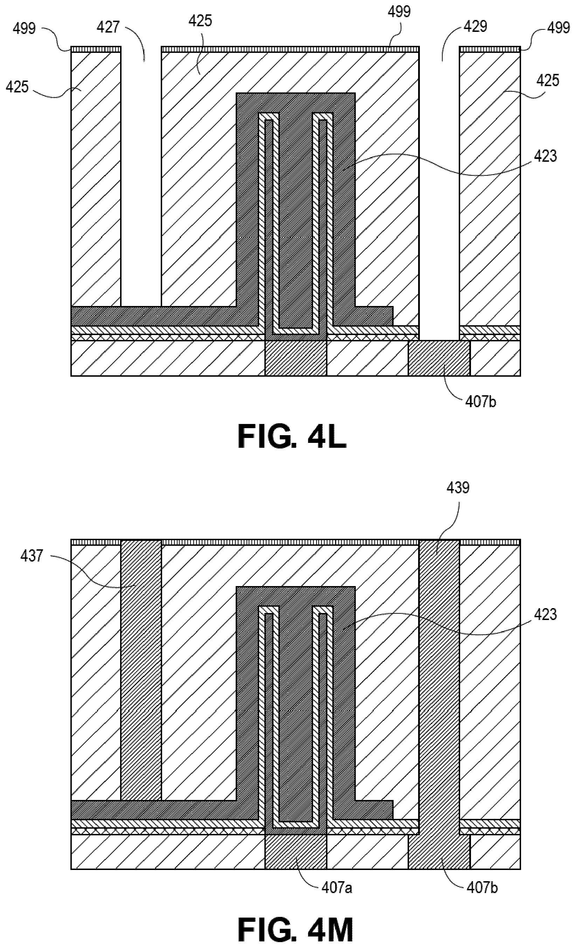

Referring now to Figure 4L, patterning and etching is performed to form first and a second via openings 427 and 429. A hardmask (HM) 499 remains over ILD material 425. In the embodiment, second via opening 429 is thus formed over second metal contact layer 407b.

Referring now to Figure 4M, metallization of previous first and a second via openings 427 and 429 is performed to form vias 437 and 439. Note that metals used to form vias 437 and 439 may include conductive material is composed of a conductive material such as, but not limited to, Cu, Al, Ti, Zr, Hf, V, Ru, Co, Ni, Pd, Pt, W, Ag, Au or alloys thereof.

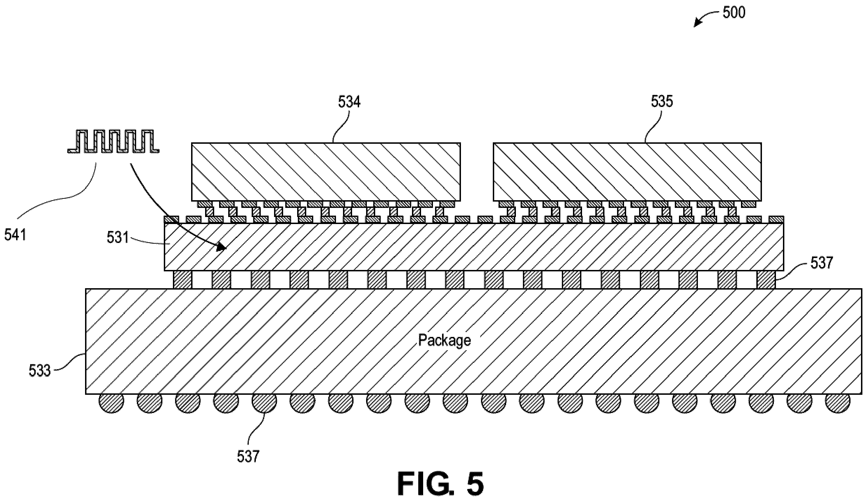

Referring now to FIG. 5, which is a cross-sectional side view of an integrated circuit (IC) device assembly including DWCs in a coupling structure, in accordance with an embodiment of the present disclosure. In embodiments, a coupling structure 531 includes an interposer (e.g., in some respects similar or the same as will be discussed with respect to Figure 6) that provides an interconnection between integrated circuit devices, e.g., logic or memory dies 534, 535 and a package 533 of another integrated circuit device, e.g., a base compute die. In embodiments, coupling structure 531 is an active interposer and unlike a typical passive silicon interposer, includes active components of a system. In embodiments, coupling structure 531 includes a substrate in which a plurality of double-walled capacitors (DWC) 541 are disposed. In embodiments, coupling structure 531 includes metal interconnects to provide electrical routing connections between dies 534 and 535 and the plurality of DWCs 541 provide capacitance to assist the substrate in providing the electrical signal routing connections between dies 534 and 535.

In embodiments, the plurality of DWCs 541 include a plurality of cylindrical double-walled capacitors including alternating dielectric layers and metal layers, as described in connection with FIG.1. In embodiments, coupling structure 531 further includes a plurality of metal interconnects, vias, and passive or active embedded devices (not shown) coupled to the plurality of DWCs 541. Coupling structure 531 may provide interconnection between dies 534 and 535 and a package substrate 533, which may further be coupled to a circuit board. Further details regarding coupling structure 531 are also discussed with respect to Figure 6. Note that in embodiments, DWCs 541 also may be included in integrated circuit structures (e.g., Figure 3) of dies 534, 535, or in a die of package 533.

In an embodiment, interconnect structures such as trenches and interconnect lines, described herein and in connection with Figure 3 are composed of one or more metal or metal-containing conductive structures. The conductive interconnect lines are also sometimes referred to in the art as traces, wires, lines, metal, interconnect lines or simply interconnects. In a particular embodiment, each of the interconnect lines includes a barrier layer and a conductive fill material. In an embodiment, the barrier layer is composed of a metal nitride material, such as tantalum nitride or titanium nitride. In an embodiment, the conductive fill material is composed of a conductive material such as, but not limited to, Cu, Al, Ti, Zr, Hf, V, Ru, Co, Ni, Pd, Pt, W, Ag, Au or alloys thereof.

In an embodiment, ILD materials described herein are composed of or include a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof.

It is to be appreciated that not all aspects of the processes described above need be practiced to fall within the scope of embodiments of the present disclosure.

It should be noted that implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, rare earth elements such as scandium, yttrium and lanthanum, aluminum, zirconium, barium, strontium, lead, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and borides or carbides of these metals such as hafnium boride, hafnium carbide, zirconium boride, zirconium carbide, titanium boride, titanium carbide, tantalum boride, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

Referring now to Figure 6, which is a cross-sectional side view of an integrated circuit (IC) device that may include one or more backend DWCs, in accordance with one or more of the embodiments disclosed herein.

Referring to Figure 6, an IC device 600, which may be similar to IC device 200 as described in connection with Figure 2, is formed on a substrate 602 (e.g., a semiconductor wafer) and may be included in a die, which may be singulated or included in a wafer. Although a few examples of materials from which the substrate 602 may be formed are described above, any material that may serve as a foundation for an IC device 600 may be used.

The IC device 600 may include one or more device layers, such as device layer 604 disposed on the substrate 602. The device layer 604 may include features of one or more devices (e.g., similar to devices 316 and 317 of Figure 3), e.g., transistors 640 (e.g., TFTs described above) formed on the substrate 602. The device layer 604 may include, for example, one or more source and/or drain (S/D) regions 620, a gate 622 to control current flow in the transistors 640 between the S/D regions 620, and one or more S/D contacts 624 to route electrical signals to/from the S/D regions 620. The transistors 640 may include additional features not depicted for the sake of clarity, such as device isolation regions, gate contacts, and the like. The transistors 640 are not limited to the type and configuration depicted in Figure 6 and may include a wide variety of other types and configurations such as, for example, planar transistors, non-planar transistors, or a combination of both. Non-planar transistors may include Fin-based transistors, such as double-gate transistors or tri-gate transistors, and wrap-around or all-around gate transistors, such as nanoribbon and nanowire transistors.

Electrical signals, such as power and/or input/output (I/O) signals, may be routed to and/or from the transistors 640 of the device layer 604 through one or more interconnect layers disposed on the device layer 604 (illustrated in Figure 6 as interconnect layers 606-610). For example, electrically conductive features of the device layer 604 (e.g., the gate 622 and the S/D contacts 624) may be electrically coupled with the interconnect structures 628 of the interconnect layers 606-610. The one or more interconnect layers 606-610 may form an interlayer dielectric (ILD) stack 619 of the IC device 600. The interconnect layers may include DWCs as described and shown in connection with Figures 1 and 2.

The interconnect structures 628 may be arranged within the interconnect layers 606-610 to route electrical signals according to a wide variety of designs (in particular, the arrangement is not limited to the particular configuration of interconnect structures 628 depicted in Figure 6). Although a particular number of interconnect layers 606-610 is depicted in Figure 6, embodiments of the present disclosure include IC devices having more or fewer interconnect layers than depicted.

In some embodiments, the interconnect structures 628 may include trench structures 628a (sometimes referred to as "lines") and/or via structures 628b filled with an electrically conductive material such as a metal. The trench structures 628a may be arranged to route electrical signals in a direction of a plane that is substantially parallel with a surface of the substrate 602 upon which the device layer 604 is formed. For example, the trench structures 628a may route electrical signals in a direction in and out of the page from the perspective of Figure 6. The via structures 628b (e.g., similar to the vias 338 of Figure 3) may be arranged to route electrical signals in a direction of a plane that is substantially perpendicular to the surface of the substrate 602 upon which the device layer 604 is formed. In some embodiments, the via structures 628b may electrically couple trench structures 628a of different interconnect layers 606-610 together.

The interconnect layers 606-610 may include a dielectric material 626 disposed between the interconnect structures 628, as shown in Figure 6. In some embodiments, the dielectric material 626 disposed between the interconnect structures 628 in different ones of the interconnect layers 606-610 may have different compositions; in other embodiments, the composition of the dielectric material 626 between different interconnect layers 606-610 may be the same. In either case, such dielectric materials may be referred to as inter-layer dielectric (ILD) materials.

A first interconnect layer 606 (referred to as Metal 1 or "M1") may be formed directly on the device layer 604. In some embodiments, the first interconnect layer 606 may include trench structures 628a and/or via structures 628b, as shown. The trench structures 628a of the first interconnect layer 606 may be coupled with contacts (e.g., the S/D contacts 624) of the device layer 604.

A second interconnect layer 608 (referred to as Metal 2 or "M2") may be formed directly on the first interconnect layer 606. In some embodiments, the second interconnect layer 608 may include via structures 628b to couple the trench structures 628a of the second interconnect layer 608 with the trench structures 628a of the first interconnect layer 606. Although the trench structures 628a and the via structures 628b are structurally delineated with a line within each interconnect layer (e.g., within the second interconnect layer 608) for the sake of clarity, the trench structures 628a and the via structures 628b may be structurally and/or materially contiguous (e.g., simultaneously filled during a dual-damascene process) in some embodiments.

A third interconnect layer 610 (referred to as Metal 3 or "M3") (and additional interconnect layers, as desired) may be formed in succession on the second interconnect layer 608 according to similar techniques and configurations described in connection with the second interconnect layer 608 or the first interconnect layer 606.

The IC device 600 may include a solder resist material 634 (e.g., polyimide or similar material) and one or more bond pads 636 formed on the interconnect layers 606-610. The bond pads 636 may be electrically coupled with the interconnect structures 628 and configured to route the electrical signals of the transistor(s) 640 to other external devices. For example, solder bonds may be formed on the one or more bond pads 636 to mechanically and/or electrically couple a chip including the IC device 600 with another component (e.g., a circuit board). The IC device 600 may have other alternative configurations to route the electrical signals from the interconnect layers 606-610 than depicted in other embodiments. For example, the bond pads 636 may be replaced by or may further include other analogous features (e.g., posts) that route the electrical signals to external components.

Figure 7 is a cross-sectional side view of an integrated circuit (IC) device assembly that may include one or more thin film transistors having electrostatic double gates, in accordance with one or more of the embodiments disclosed herein.

Referring to Figure 7, an IC device assembly 700 includes components having one or more integrated circuit structures described herein. The IC device assembly 700 includes a number of components disposed on a circuit board 702 (which may be, e.g., a motherboard). The IC device assembly 700 includes components disposed on a first face 740 of the circuit board 702 and an opposing second face 742 of the circuit board 702. Generally, components may be disposed on one or both faces 740 and 742. In particular, any suitable ones of the components of the IC device assembly 700 may include a number of the DWCs disclosed herein.

In some embodiments, the circuit board 702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 702. In other embodiments, the circuit board 702 may be a non-PCB substrate.

The IC device assembly 700 illustrated in Figure 7 includes a package-on-interposer structure 736 (similar to interposer 531 as described in connection with Figure 5) coupled to the first face 740 of the circuit board 702 by coupling components 716. The coupling components 716 may electrically and mechanically couple the package-on-interposer structure 736 to the circuit board 702, and may include solder balls (as shown in Figure 7), male and female portions of a socket, an adhesive, an underfill material, and/or any other suitable electrical and/or mechanical coupling structure.

The package-on-interposer structure 736 may include an IC package 720 coupled to an interposer 704 by coupling components 718. The coupling components 718 may take any suitable form for the application, such as the forms discussed above with reference to the coupling components 716. Although a single IC package 720 is shown in Figure 7, multiple IC packages may be coupled to the interposer 704. It is to be appreciated that additional interposers may be coupled to the interposer 704. The interposer 704 may provide an intervening substrate used to bridge the circuit board 702 and the IC package 720. The IC package 720 may be or include, for example, a die (the die 334 or 335 of Figure 3), an IC device (e.g., the IC device 200 of Figure 2), or any other suitable component. Generally, the interposer 704 may spread a connection to a wider pitch or reroute a connection to a different connection. For example, the interposer 704 may couple the IC package 720 (e.g., a die) to a ball grid array (BGA) of the coupling components 716 for coupling to the circuit board 702. In the embodiment illustrated in Figure 7, the IC package 720 and the circuit board 702 are attached to opposing sides of the interposer 704. In other embodiments, the IC package 720 and the circuit board 702 may be attached to a same side of the interposer 704. In some embodiments, three or more components may be interconnected by way of the interposer 704.

The interposer 704 may be formed of an epoxy resin, a fiberglass-reinforced epoxy resin, a ceramic material, or a polymer material such as polyimide. In some implementations, the interposer 704 may be formed of alternate rigid or flexible materials that may include the same materials described above for use in a semiconductor substrate, such as silicon, germanium, and other group III-V and group IV materials. The interposer 704 may include metal interconnects 708 and vias 710 (similar or the same as metal interconnects 338 and 328 of Figure 3), including but not limited to through-silicon vias (TSVs) 706. The interposer 704 may further include embedded devices 714, including both passive and active devices. Such devices may include, but are not limited to, capacitors (e.g., DWCs as described in Figure 1), decoupling capacitors, resistors, inductors, fuses, diodes, transformers, sensors, electrostatic discharge (ESD) devices, and memory devices. More complex devices such as radiofrequency (RF) devices, power amplifiers, power management devices, antennas, arrays, sensors, and microelectromechanical systems (MEMS) devices may also be formed on the interposer 704. The package-on-interposer structure 736 may take the form of any of the package-on-interposer structures known in the art.

The IC device assembly 700 may include an IC package 724 coupled to the first face 740 of the circuit board 702 by coupling components 722. The coupling components 722 may take the form of any of the embodiments discussed above with reference to the coupling components 716, and the IC package 724 may take the form of any of the embodiments discussed above with reference to the IC package 720.

The IC device assembly 700 illustrated in Figure 7 includes a package-on-package structure 734 coupled to the second face 742 of the circuit board 702 by coupling components 728. The package-on-package structure 734 may include an IC package 726 and an IC package 732 coupled together by coupling components 730 such that the IC package 726 is disposed between the circuit board 702 and the IC package 732. The coupling components 728 and 730 may take the form of any of the embodiments of the coupling components 716 discussed above, and the IC packages 726 and 732 may take the form of any of the embodiments of the IC package 720 discussed above. The package-on-package structure 734 may be configured in accordance with any of the package-on-package structures known in the art.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

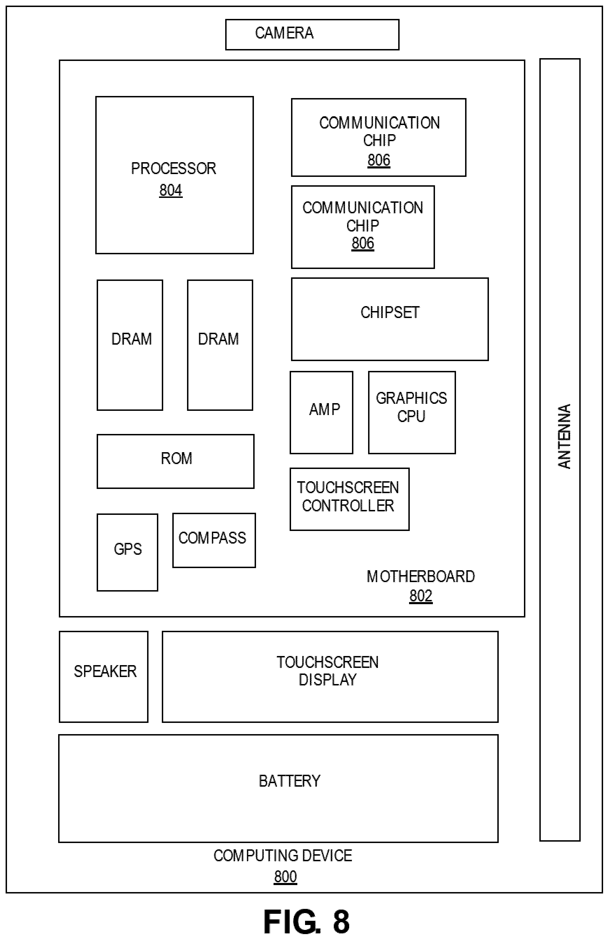

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the disclosure, the integrated circuit die of the processor includes one or more DWCs, in accordance with implementations of embodiments of the disclosure. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of embodiments of the disclosure, the integrated circuit die of the communication chip includes one or more DWCs, in accordance with implementations of embodiments of the disclosure.

In further implementations, another component housed within the computing device 800 may contain an integrated circuit die that includes DWCs, in accordance with implementations of embodiments of the disclosure.

In various implementations, the computing device 800 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

Thus, embodiments described herein include backend DWCs included in interconnect layers or coupling structures of logic devices or assemblies.

Example 1 includes an integrated circuit (IC) structure, comprising a plurality of backend double-walled capacitors (DWC);a first interconnect layer over a substrate; and a second interconnect layer over the first interconnect layer, wherein the plurality of DWCs are disposed in the first interconnect layer or the second interconnect layer to provide capacitance to assist the first interconnect layer and the second interconnect layer in providing electrical signal routing to one or more devices in the IC structure.

Example 2 includes the IC structure of Example 1, wherein the first interconnect layer and the second interconnect layer are included in a stack of interconnect layers of an IC logic structure.

Example 3 includes the IC structure of Example 1, wherein the plurality of backend DWCs comprise a plurality of cylindrical double-walled capacitors including alternating dielectric layers and metal layers.

Example 4 includes the IC structure of Example 3, wherein the plurality of backend DWCs are arranged in a honeycomb or Manhattan configuration.

Example 5 includes the IC structure of Example 1, wherein the plurality of double-walled capacitors include metal layers comprising at least one or more of Cu, TiN, TaN, Ti, Ta, Mo, W, Ru, and Graphene.

Example 6 includes the IC structure of Example 1, wherein the plurality of backend DWCs include dielectric layers comprising at least one of HfO₂, ZrO₂, TiO₂, SrTiO₂, Al₂O₃, SiO₂, SiN, AIN, ZrN, HfN, SiON, SiC, GaN, or rare earth oxides of the form including M₂O₃.

Example 7 includes the IC structure of Example 1, wherein the one or more devices in the IC structure include one or more N-channel metal-oxide-semiconductor field-effect transistor (NMOS) transistors and P-channel metal-oxide-semiconductor field-effect transistor (PMOS) transistors.

Example 8 includes the IC structure of Example 7, wherein one or more transistors are included in an interconnect layer different from the first interconnect layer or the second interconnect layer where the plurality of backend double-walled capacitors (DWC) are disposed.

Example 9 includes any one of the IC structures of Examples 1-8, wherein the IC structure is a logic IC.

Example 10 includes a coupling structure, comprising a plurality of backend double-walled capacitors (DWC); a substrate including the plurality of backend double-walled capacitors (DWC), wherein the substrate includes metal interconnects to provide electrical routing connection between a first die and a second die and the plurality of backend DWCs provides capacitance to assist the substrate in providing the electrical signal routing connection between the first die and the second die.

Example 11 includes the coupling structure of Example 10, wherein the plurality of DWCs comprise a plurality of cylindrical DWCs including alternating dielectric layers and metal layers.

Example 12 includes the coupling structure of Example 10, wherein the substrate comprises an interposer and further includes a plurality of metal interconnects, vias, and passive or active embedded devices coupled to the plurality of DWCs.

Example 13 includes the coupling structure of any one of Examples 10-12, wherein the coupling structure provides interconnection between the first and the second die and a package substrate coupled to a circuit board.

Example 14 includes a computing device, comprising: a circuit board, and a component coupled to the circuit board, the component including an integrated circuit (IC) structure, comprising: a plurality of backend double-walled capacitors (DWC); a first interconnect layer over a substrate; and a second interconnect layer over the first interconnect layer, wherein the plurality of backend DWCs are disposed in the first interconnect layer or the second interconnect layer to provide capacitance to assist the first interconnect layer and the second interconnect layer in providing electrical signal routing to devices in the IC structure.

Example 15 includes the computing device of Example 14, wherein the component is included in a packaged logic IC die.

Example 16 includes the computing device of Example 14, wherein the plurality of double-walled capacitors (DWCs) comprise cylindrical double-walled capacitors including alternating dielectric layers and metal layers.

Example 17 includes the computing device of Example 14, wherein devices in the IC structure are included in an interconnect layer different from the first interconnect layer or the second interconnect layer including the plurality of backend DWCs.

Example 18 includes the computing device of Example 14, further including a memory coupled to the circuit board.

Example 19 includes the computing device of Example 14, wherein the first interconnect layer and the second interconnect layer are included in a stack of interconnect layers of the IC structure.

Example 20 includes the computing device of any one of Examples 14-19, wherein the plurality of backend DWCs include dielectric layers comprising at least one of HfO₂, ZrO₂, TiO₂, SrTiO₂, Al₂O₃, SiO₂, SiN, AIN, ZrN, HfN, SiON, SiC, and GaN, or rare earth oxides of forms including M₂O₃.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

## Claims

1. An integrated circuit (IC) structure, comprising
a plurality of backend double-walled capacitors (DWC);
a first interconnect layer over a substrate; and
a second interconnect layer over the first interconnect layer, wherein the plurality of DWCs are disposed in the first interconnect layer or the second interconnect layer to provide capacitance to assist the first interconnect layer and the second interconnect layer in providing electrical signal routing to one or more devices in the IC structure.

2. The IC structure of claim 1, wherein the first interconnect layer and the second interconnect layer are included in a stack of interconnect layers of an IC logic structure.

3. The IC structure of claim 1, wherein the plurality of backend DWCs comprise a plurality of cylindrical double-walled capacitors including alternating dielectric layers and metal layers.

4. The IC structure of claim 3, wherein the plurality of backend DWCs are arranged in a honeycomb or Manhattan configuration.

5. The IC structure of claim 1, wherein the plurality of double-walled capacitors include metal layers comprising at least one or more of Cu, TiN, TaN, Ti, Ta, Mo, W, Ru, and Graphene.

6. The IC structure of claim 1, wherein the plurality of backend DWCs include dielectric layers comprising at least one of HfO₂, ZrO₂, TiO₂, SrTiO₂, Al₂O₃, SiO₂, SiN, AIN, ZrN, HfN, SiON, SiC, GaN, or rare earth oxides of the form including M₂O₃.

7. The IC structure of claim 1, wherein the one or more devices in the IC structure include one or more N-channel metal-oxide-semiconductor field-effect transistor (NMOS) transistors and P-channel metal-oxide-semiconductor field-effect transistor (PMOS) transistors.

8. The IC structure of claim 7, wherein one or more transistors are included in an interconnect layer different from the first interconnect layer or the second interconnect layer where the plurality of backend double-walled capacitors (DWC) are disposed.

9. The IC structure of claim 1, 2, 3, 4, 5, 6, 7 or 8, wherein the IC structure is a logic IC.

10. A method of fabricating an integrated circuit (IC) structure, the method comprising
forming a plurality of backend double-walled capacitors (DWC);
forming a first interconnect layer over a substrate; and
forming a second interconnect layer over the first interconnect layer, wherein the plurality of DWCs are disposed in the first interconnect layer or the second interconnect layer to provide capacitance to assist the first interconnect layer and the second interconnect layer in providing electrical signal routing to one or more devices in the IC structure.

11. The method of claim 10, wherein the first interconnect layer and the second interconnect layer are included in a stack of interconnect layers of an IC logic structure.

12. The method of claim 10, wherein the plurality of backend DWCs comprise a plurality of cylindrical double-walled capacitors including alternating dielectric layers and metal layers.

13. The method of claim 12, wherein the plurality of backend DWCs are arranged in a honeycomb or Manhattan configuration.

14. The method of claim 10, wherein the plurality of double-walled capacitors include metal layers comprising at least one or more of Cu, TiN, TaN, Ti, Ta, Mo, W, Ru, and Graphene.

15. The method of claim 10, wherein the plurality of backend DWCs include dielectric layers comprising at least one of HfO₂, ZrO₂, TiO₂, SrTiO₂, Al₂O₃, SiO₂, SiN, AIN, ZrN, HfN, SiON, SiC, GaN, or rare earth oxides of the form including M₂O₃.
